# EUROPEAN PATENT APPLICATION

(11) **EP 2 579 352 A1**
(43) Date of publication of application: **10.04.2013**
(21) Application number: 11786500.6
(22) Date of filing: 16.05.2011
(51) Int. Cl.: H01L 51/50, H05B 33/10

(54) **ORGANIC EL ELEMENT**

(30) Priority: 25.05.2010 JP 2010118939
(71) Applicant: Nippon Seiki Co., Ltd., Niigata 940-8580 (JP)
(72) Inventor: TADOKORO,Toyoyasu, Niigata (JP)
(74) Representative: Jackson, Richard Eric
(86) International application number: PCT/JP2011/061139
(87) International publication number: WO 2011/148801

(57) **Abstract**

Disclosed is an organic EL element which requires a low electric power and can exhibit high reliability under high temperature environments.Specifically disclosed is an organic EL element produced by forming, between an anode (2) and a cathode (4) by lamination, an organic layer (3) which comprises at least a light-emitting layer (3b). The light-emitting layer (3b) is composed of at least a host material that has a ratio of the electron mobility (µeEM) to the hole mobility (µhEM) (i.e., a µeEM/µhEM ratio) of 0.6 to 10 inclusive, a light-emitting dopant that can emit light, and a hole-transporting dopant. The light-emitting layer (3b) is characterized in that the ratio of the hole mobility (µhHT) of the hole-transporting dopant to the electron mobility (µeEM) of the host material (i.e., a µhHT/µeEM ratio) is 0.1 to 10 inclusive.

## Description

### [Technical Field]

The present invention relates to an organic EL (an electroluminescent) element, and more particularly, to a low voltage operation and a high efficiency operation of an organic EL element.

### [Background Art]

In a convention art, there has been known an organic EL element which is a self-light emitting element made of an organic material, for example, which is formed by sequentially stacking a first electrode made of ITO (Indium Tin Oxide) and the like, which serves as an anode, an organic layer having at least a light-emitting layer, and a non-light transmissive second electrode made of aluminum (Al) and the like, which serves as a cathode.

The organic EL element is constituted in such a manner that holes are injected from the first electrode, electrons are injected from the second electrode, and the holes and the electrons are subject to recombination in a light-emitting layer, whereby light is emitted. An organic EL display using the organic EL element has been employed in an in-vehicle display apparatus such as a vehicle instrument requiring instantaneous reading of display because it has excellent visibility due to self-emission, and excellent impact resistance or excellent responsibility in a low temperature environment due to a complete solid element.

### [Citation List]

### [Patent Literature]

[PTL 1] Japanese Unexamined Patent Application Publication No. 2005-108726

### [Summary of Invention]

### [Technical Problem]

Particularly, an organic EL element employed in an in-vehicle display apparatus requires high reliability in an extensive temperature environment and low power operation. In order to improve the reliability at low power in a high temperature environment, a low voltage operation and a high efficiency operation are important. On the other hand, there is a problem that as a method for achieving a low voltage operation and a high efficiency operation, it has been considered to form an electron transporting layer with high electron mobility between a light-emitting layer and a cathode. However, when the electron mobility of the electron transporting layer is high, since the supply of the electrons is excessive, carrier balance is broken, so that a hole transporting layer formed between the light-emitting layer and an anode is degraded by the electrons and thus the lifetime becomes shorter.

Furthermore, as disclosed in Patent Literature 1, there is a method for adding an assist dopant complementing carrier transportability of a host material to a light-emitting layer, and allowing materials having opposite carrier transportabilities, that is, a hole transporting material and an electron transporting material, to be mixed in the light-emitting layer, thereby using the light-emitting layer itself as a bipolar (both carrier transportabilities) and enhancing recombination probability in the light-emitting layer, resulting in the improvement of light-emitting efficiency. However, in the method, it is important to ensure carrier balance and to further improve reliability in a high temperature environment.

Therefore, the present invention has been achieved in view of the above-described problems, and an object thereof is to provide an organic EL element with high reliability at low power in a high temperature environment.

### [Solution to Problem]

In order to achieve the above object, there is provided an organic EL element, which is formed by stacking an organic layer including at least a light-emitting layer between an anode and a cathode, wherein
the light-emitting layer includes at least a host material having a ratio (µeEM/µhEM) of electron mobility (µeEM) with respect to hole mobility (µhEM) being equal to or more than 0.6 and equal to or less than 10, a light emitting dopant emitting light, and a hole transporting dopant,
a ratio (µhHT/µeEM) of hole mobility (µhHT) of the hole transporting dopant with respect to the electron mobility (µeEM) of the host material is equal to or more than 0.1 and equal to or less than 10.

Furthermore, concentration of the hole transporting dopant in the light-emitting layer is equal to or less than 50 weight%.

A difference in ionization potential between the light emitting dopant and the host material is equal to or more than 0.05 eV.

### [Advantageous Effects of Invention]

The present invention relates to an organic EL element, and can provide an organic EL element with high reliability at low power in a high temperature environment.

### [Brief Description of Drawings]

[FIG. 1] FIG. 1 is a diagram illustrating an organic EL element according to an embodiment of the present invention.
[FIG. 2] FIG. 2 is a diagram illustrating experimental results of examples 1 to 7 and comparative examples 1 to 4 of the present invention.

### [Description of Embodiments]

Hereinafter, an embodiment of the present invention will be described with reference to the accompanying drawings.

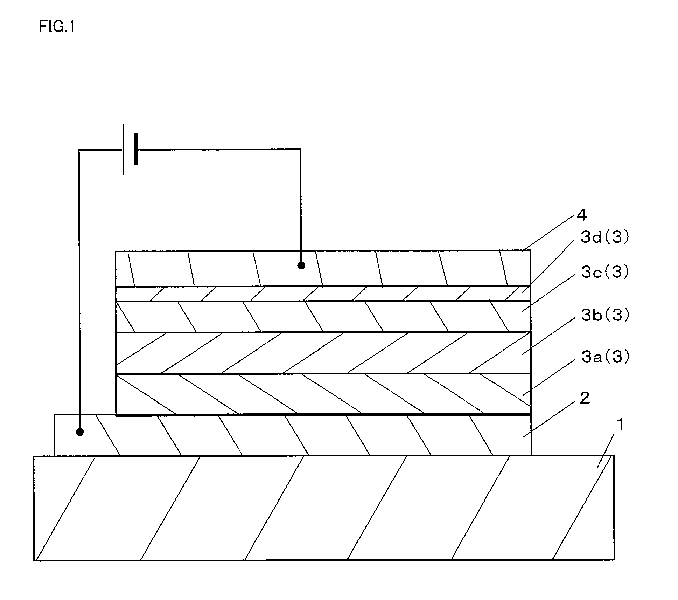

FIG. 1 is a diagram illustrating an embodiment of the present invention. An organic EL element of the present embodiment includes a support substrate 1, a first electrode 2 serving as an anode, an organic layer 3, and a second electrode 4 serving as a cathode. In addition, the organic EL element is sealed by arranging a sealing substrate coated with moisture absorbent on the support substrate 1. However, in FIG. 1, the sealing substrate is omitted.

The support substrate 1 is a rectangular substrate made of, for example, a light transmissive glass material. On the support substrate 1, the first electrode 2, the organic layer 3, and the second electrode 4 are sequentially stacked.

The first electrode 2 serves as an anode from which holes are injected, is formed of an oxide transparent conductive film obtained by forming indium tin oxide (ITO) on the support substrate 1 as a layer through a sputtering method and the like, and is patterned in a predetermined shape through photo-etching and the like. Furthermore, the surface of the first electrode 2 is subject to a surface process such as a UV/O₃ process or a plasma process.

The organic layer 3 is a multilayer including at least a light-emitting layer, and is formed on the first electrode 2. In the present embodiment, a hole injection transporting layer 3a, a light-emitting layer 3b, an electron transporting layer 3c, and an electron injecting layer 3d are sequentially stacked from the side of the first electrode 2.

The hole injection transporting layer 3a has a function of receiving holes from the first electrode 2 and transferring the holes to the light-emitting layer 3b, and is obtained by forming, for example, a hole transporting material such as amine-based compound as a layer having a thickness of about 15 nm to 40 nm through a deposition method and the like.

The light-emitting layer 3b is obtained by adding at least a light emitting dopant emitting light and a hole transporting dopant to a host material through codeposition and the like, wherein the host material has a ratio (µeEM/µhEM) of electron mobility (hereinafter, electron mobility of the host material will be written as µeEM) with respect to hole mobility (hereinafter, hole mobility of the host material will be written as µhEM), which is equal to or more than 0.6 and is equal to or less than 10 (0.6 ≤ µeEM/µhEM ≤ 10). The host material is normally included in the light-emitting layer 3b at the highest ratio, enables transport of holes and electrons, has a function of allowing the light emitting dopant to emit light through recombination of the holes and the electrons in the molecules of the host material, and has an energy gap of about 3.0 eV. The light emitting dopant has a function of emitting light in response to the recombination of the holes and the electrons, and is made of, for example, a fluorescent substance showing green light emission, wherein the difference in Ip (ionization potential) between the host material and the fluorescent substance is equal to or more than 0.05 eV. The hole transporting dopant is a material having a function of improving injection efficiency of holes from the first electrode 2 to the light-emitting layer 3b, having the ratio (µhHT/µeEM) of hole mobility of the hole transporting dopant (hereinafter, hole mobility of the hole transporting dopant will be written as µhHT) with respect to the electron mobility µeEM of the host material being equal to or more than 0.1 and equal to or less than 10 (0.1 ≤ µhHT/µeEM ≤ 10), having concentration of 50 weight% or less in the light-emitting layer 3b, and having a glass transition temperature of 85°C more, preferably, 110°C more.

The electron transporting layer 3c has a function of transferring the electrons to the light-emitting layer 3b, and is obtained by forming, for example, an electron transporting material such as alumiquinolinol (Alq₃) as a layer through a vacuum deposition method and the like.

The electron injecting layer 3d has a function of receiving the electrons from the second electrode 4, and is obtained by forming, for example, lithium fluoride (LiF) or lithium quinoline (Liq) as a thin film through a vacuum deposition method and the like.

The second electrode 4 serves as a cathode into which the electrons are injected, and is that which is formed of a conductive film formed such that a low resistance conductive material such as aluminum (Al) is layered, by way of deposition method and the like, on the electron injecting layer 3d.

The organic EL element is configured by the above elements.

As a result of earnest efforts, the present applicants have found that it is possible to obtain an element with high reliability at low power in a high temperature environment by defining the hole mobility µhEM and the electron mobility µeEM of the host material in a predetermined range, and defining the electron mobility µeEM of the host material and the hole mobility µhHT of the hole transporting dopant in a predetermined range, thereby stabilizing carrier balance of an organic EL element, resulting in the present invention. That is, the light-emitting layer 3b is made of the host material having a ratio (µeEM/µhEM) of the electron mobility µeEM with respect to the hole mobility µhEM, which is equal to or more than 0.6 and equal to or less than 10 (0.6 ≤ µeEM/µLhEM ≤ 10), and the hole transporting dopant, which has a ratio (µhHT/µeEM) of the hole mobility µhHT of the hole transporting dopant with respect to the electron mobility µeEM of the host material being equal to or more than 0.1 and equal to or less than 10 (0.1 ≤ µhHT/µhEM ≤ 10), is added to the light-emitting layer 3b, so that it is possible to stabilize the carrier balance to achieve a low voltage operation and a high efficiency operation, resulting in the obtainment of an organic EL element with high reliability at low power in a high temperature environment. The host material transports electrons and holes, enables recombination of the electrons and the holes, and forms excitons. When the mobility difference between the electrons and the holes is large, since an exciton formation area may be biased and light emission may not be uniformly performed in the light-emitting layer 3b, so that the excitons are recombined with one another, resulting in the reduction of light-emitting efficiency. Moreover, electrons and holes, which are not recombined and overflowed, have an influence on the hole injection transporting layer 3a or the electron transporting layer 3c, thereby deteriorating materials, resulting in the degradation of lifetime characteristics. In order to match the carrier balance, it is necessary to adjust the mobility ratio of the electrons and the holes of the host material to a certain range. Specifically, as with the present invention, when the mobility ratio satisfies 0.6 ≤ µeEM/µhEM ≤ 10, the effects are obtained. Furthermore, the hole transporting dopant added to the host material has an influence on a low voltage operation and lifetime characteristics, and in the host material with high electron mobility µeEM, electrons, accumulated and overflowed at an interface between the hole injection transporting layer 3a and the light-emitting layer 3b, deteriorate the hole transporting material of the hole injection transporting layer 3a, resulting in the degradation of the lifetime characteristics. However, by adding the hole transporting dopant, it is possible to reduce the accumulation of electrons and to suppress the deterioration of the material of the hole injection transporting layer 3a. Specifically, as with the present invention, when the ratio of the hole mobility µhHT of the hole transporting dopant with respect to the electron mobility µeEM of the host material satisfies 0.1 ≤ µhHT/µeEM ≤ 10, excellent suppression effects are obtained.

Furthermore, the hole transporting dopant is added such that the concentration of the hole transporting dopant in the light-emitting layer 3b is equal to or less than 50 weight%, so that it is possible to maintain light-emitting efficiency and achieve a low voltage operation without degrading lifetime characteristics. The concentration of the hole transporting dopant in the light-emitting layer 3b has a significant influence on driving voltage, efficiency, and lifetime characteristics. When the concentration of the hole transporting dopant is high, voltage of current-voltage characteristics is reduced due to the mobility of the hole transporting dopant. However, since the host material that is associated with the light emission is reduced, light-emitting efficiency is reduced. Therefore, in order to produce the same luminance, it is necessary to supply a large amount of current, resulting in the reduction of lifetime. In the present invention, the light-emitting efficiency is not reduced up while the concentration of the hole transporting dopant increases until the same as that of the host material in the light-emitting layer 3b. However, when the concentration of the hole transporting dopant exceeds 55 weight%, the light-emitting efficiency is significantly reduced.

Furthermore, the difference in Ip between the light emitting dopant and the host material is allowed to be equal to or more than 0.5 eV, so that it is possible to efficiently transfer the energy of the excitons made of the host material from the host material to the light emitting dopant, resulting in the obtainment of high light-emitting efficiency. Since the difference in Ip between the light emitting dopant and the host material has an influence on the transfer efficiency of the energy of the excitons, when the Ip difference is equal to or less than 0.05 eV, a ratio, at which the light emitting dopant itself forms excitons using holes and electrons and emits light, is increased, so that a light-emitting ratio due to energy transfer of the excitons made of the host material is reduced, resulting in the reduction of the light-emitting efficiency.

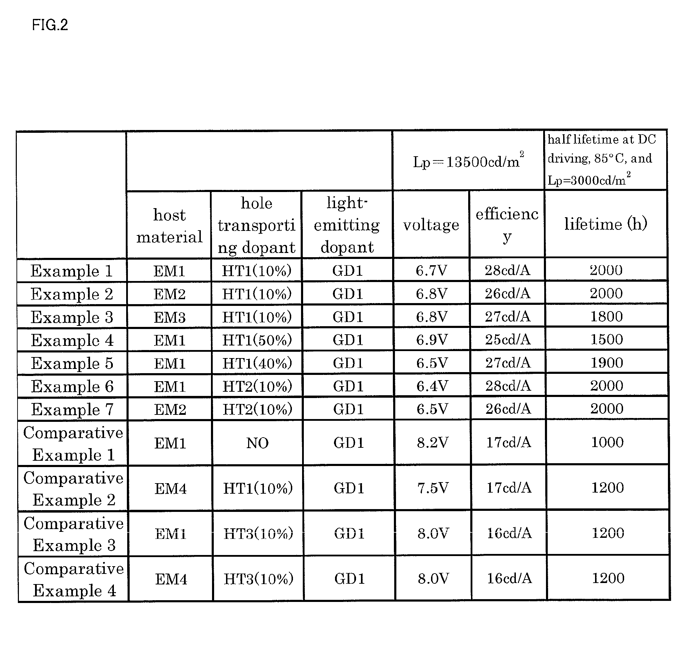

Hereinafter, embodiments of the present invention will be further described. However, the present invention is not limited thereto. FIG. 2 illustrates performance comparison of each example of each comparative example.

### Example 1

The first electrode 2 having a thickness of 145 nm and made of ITO was formed on the support substrate 1, and the hole injection transporting layer 3a having a thickness of 30 nm and made of a hole transporting material HT1 was formed on the first electrode 2. Furthermore, the light-emitting layer 3b having a thickness of 50 nm was formed on the hole injection transporting layer 3a by containing a host material EM1, the light emitting dopant made of a fluorescent dopant GD1 showing green light emission, and the hole transporting dopant made of a hole transporting material HT1 into the hole injection transporting layer 3a at a ratio of 45:1.5:5. The host material EM1 has Ip of 5.9 eV, Ea (electron affinity) of 2.9 eV, electron mobility µeEM of 3 x 10⁻³ cm²/Vs, and hole mobility µhEM of 2 x 10⁻³ cm²/Vs, and a ratio (µeEM/µhEM) of the electron mobility µeEM with respect to the hole mobility µhEM is 1.5. The fluorescent dopant GD1 has Eg (energy gap) of 2.4 eV, and Ip of 5.8 eV, and difference in Ip between the host material EM1 and the fluorescent dopant GD1 is 0.1 eV. The hole transporting material HT1 has Tg (glass transition temperature) of 130C°, Ip of 5.4 eV, hole mobility µhHT of 4 x 10⁻⁴ cm²/Vs, and concentration of 10 weight% in the light-emitting layer 3b. Furthermore, a ratio (µhHT/µeEM) of the hole mobility µhHT of the hole transporting material HT1 with respect to the electron mobility µeEM of the host material EM1 is about 0.13. Moreover, an electron transporting material ET1 having a thickness of 25 nm was formed on the light-emitting layer 3b as the electron transporting layer 3c. The electron transporting material ET1 has Ip of 5.8 eV, Ea of 3.0 eV, and electron mobility µe of 5 x 10⁻⁶ cm²/Vs. Moreover, Lif having a thickness of 1 nm was formed on the electron transporting layer 3c as the electron injecting layer 3d, and Al having a thickness of 100 nm was formed on the electron injecting layer 3d as the second electrode 4, thereby preparing the organic EL element. The example 1 showed green light emission, and characteristics thereof were that driving voltage E was 6.7 V and current efficiency L/J was 28 cd/A at emission luminance Lp of 13500 cd/m², and half lifetime at the time of DC driving at initial luminance Lp of 3000 cd/m² in a high temperature environment of 85°C exceeded 2000 hours.

### Example 2

Furthermore, in example 2, except that the host material of the light-emitting layer 3b was changed to a host material EM2, an organic EL element was prepared and characteristics thereof were measured similarly to the example 1. In addition, the host material EM2 has Ip of 5.9 eV, Ea of 2.9 eV, electron mobility µeEM of 6 x 10⁻⁴ cm²/Vs, and hole mobility µhEM of 1 x 10⁻³ cm²/Vs, and a ratio (µeEM/µhEM) of the electron mobility µeEM with respect to the hole mobility µhEM is 0.6. Furthermore, the difference in Ip between the fluorescent dopant GD1 and the host material EM2 is 0.1 eV. Furthermore, a ratio (µhHT/µeEM) of the hole mobility µhHT of the hole transporting material HT1 with respect to the electron mobility µeEM of the host material EM2 is about 0.67. The example 2 showed green light emission, and characteristics thereof were that driving voltage E is 6.8 V and current efficiency L/J was 26 cd/A at emission luminance Lp of 13500 cd/m², and half lifetime at the time of DC driving at initial luminance Lp of 3000 cd/m² in a high temperature environment of 85°C exceeded 2000 hours.

### Example 3

Furthermore, in example 3, except that the host material of the light-emitting layer 3b was changed to a host material EM3, an organic EL element was prepared and characteristics thereof were measured similarly to the example 1. In addition, the host material EM3 has Ip of 5.9 eV, Ea of 2.9 eV, electron mobility µeEM of 4 x 10⁻³ cm²/Vs, and hole mobility µhEM of 4 x 10⁻⁴ cm²/Vs, and a ratio (µeEM/µhEM) of the electron mobility µeEM with respect to the hole mobility µhEM is 10. Furthermore, the difference in Ip between the fluorescent dopant GD1 and the host material EM3 is 0.1 eV. Furthermore, a ratio (µhHT/µeEM) of the hole mobility µhHT of the hole transporting material HT1 with respect to the electron mobility µeEM of the host material EM3 is 0.1. The example 3 showed green light emission, and characteristics thereof were that driving voltage E was 6.8 V and current efficiency L/J was 27 cd/A at emission luminance Lp of 13500 cd/m², and half lifetime at the time of DC driving at initial luminance Lp of 3000 cd/m² in a high temperature environment of 85°C exceeded 1800 hours.

### Example 4

Furthermore, in example 4, except that the ratio of the host material EM1, the fluorescent dopant GD1, and the hole transporting material HT1 in the light-emitting layer 3b was set to 25:1.5:25, and the concentration of the hole transporting material HT1 in the light-emitting layer 3b was set to 50 weight%, an organic EL element was prepared and characteristics thereof were measured similarly to the example 1. The example 4 showed green light emission, and characteristics thereof were that driving voltage E was 6.9 V and current efficiency L/J was 25 cd/A at emission luminance Lp of 13500 cd/m², and half lifetime at the time of DC driving at initial luminance Lp of 3000 cd/m² in a high temperature environment of 85°C exceeded 1500 hours.

### Example 5

Furthermore, in example 5, except that the ratio of the host material EM1, the fluorescent dopant GD1, and the hole transporting material HT1 in the light-emitting layer 3b was set to 30:1.5:20, and the concentration of the hole transporting material HT1 in the light-emitting layer 3b was set to 40 weight%, an organic EL element was prepared and characteristics thereof were measured similarly to the example 1. The example 5 showed green light emission, and characteristics thereof were that driving voltage E was 6.5 V and current efficiency L/J was 27 cd/A at emission luminance Lp of 13500 cd/m², and half lifetime at the time of DC driving at initial luminance Lp of 3000 cd/m² in a high temperature environment of 85°C exceeded 1900 hours.

### Example 6

Furthermore, in example 6, except that the hole transporting dopant of the light-emitting layer 3b was changed to a hole transporting material HT2, an organic EL element was prepared and characteristics thereof were measured similarly to the example 1. In addition, the hole transporting material HT2 has Tg of 128°C, Ip of 5.5 eV, hole mobility µhHT of 3 x 10⁻³ cm²/Vs, and concentration of 10 % in the light-emitting layer 3b. Furthermore, a ratio (µhHT/µeEM) of the hole mobility µhHT of the hole transporting material HT2 with respect to the electron mobility µeEM of the host material EM1 is 1. The example 6 showed green light emission, and characteristics thereof were that driving voltage E was 6.4 V and current efficiency L/J was 28 cd/A at emission luminance Lp of 13500 cd/m², and half lifetime at the time of DC driving at initial luminance Lp of 3000 cd/m² in a high temperature environment of 85°C exceeded 2000 hours.

### Example 7

Furthermore, in example 7, except that the host material of the light-emitting layer 3b was changed to a host material EM2 and the hole transporting dopant was changed to a hole transporting material HT2, an organic EL element was prepared and characteristics thereof were measured similarly to the example 1. In the host material EM2, a ratio (µeEM/µhEM) of the electron mobility µeEM with respect to the hole mobility µhEM is 0.6. Furthermore, a ratio (µhHT/µeEM) of the hole mobility µhHT of the hole transporting material HT2 with respect to the electron mobility µeEM of the host material EM2 is 5. The example 7 showed green light emission, and characteristics thereof were that driving voltage E is 6.5 V and current efficiency L/J was 28 cd/A at emission luminance Lp of 13500 cd/m², and half lifetime at the time of DC driving at initial luminance Lp of 3000 cd/m² in a high temperature environment of 85°C exceeded 2000 hours (Lp is 3000 cd/m²).

### (Comparative example 1)

Furthermore, in comparative example 1, except that the hole transporting dopant was not contained in the light-emitting layer 3b and the ratio of the host material EM1 and the fluorescent dopant GD1 was set to 50:1.5, an organic EL element was prepared and characteristics thereof were measured similarly to the example 1. The comparative example 1 showed green light emission, and characteristics thereof were that driving voltage E was 8.2 V and current efficiency L/J is 17 cd/A at emission luminance Lp of 13500 cd/m², and half lifetime at the time of DC driving at initial luminance Lp of 3000 cd/m² in a high temperature environment of 85°C was 1000 hours.

### (Comparative example 2)

Furthermore, in comparative example 2, except that the host material of the light-emitting layer 3b was changed to a host material EM4 and the ratio of the host material EM4, the fluorescent dopant GD1, and the hole transporting material HT1 was set to 45:1.5:5, an organic EL element was prepared and characteristics thereof were measured similarly to the example 1. The host material EM4 has Ip of 5.8 eV, Ea of 2.95 eV, electron mobility µeEM of 3 x 10⁻⁶ cm²/Vs, and hole mobility µhEM of 1 x 10⁻⁸ cm²/Vs, and a ratio (µeEM/µhEM) of the electron mobility µeEM with respect to the hole mobility µhEM is 300. Furthermore, the difference in Ip between the fluorescent dopant GD1 and the host material EM4 is 0.05 eV. Furthermore, the concentration of the hole transporting material HT1 in the light-emitting layer 3b is 10 weight%. Furthermore, a ratio (µhHT/µeEM) of the hole mobility µhHT of the hole transporting material HT1 with respect to the electron mobility µeEM of the host material EM4 is about 133. The comparative example 2 showed green light emission, and characteristics thereof were that driving voltage E was 7.5 V and current efficiency L/J was 17 cd/A at emission luminance Lp of 13500 cd/m², and half lifetime at the time of DC driving at initial luminance Lp of 3000 cd/m² in a high temperature environment of 85°C was 1200 hours.

### (Comparative example 3)

Furthermore, in comparative example 3, except that the hole transporting dopant of the light-emitting layer 3b was changed to a hole transporting material HT3, an organic EL element was prepared and characteristics thereof were measured similarly to the example 1. The hole transporting material HT3 has Tg of 100C°, Ip of 5.4 eV, and hole mobility µhHT of 8 x 10⁻⁵ cm²/Vs. Furthermore, a ratio (µhHT/µeEM) of the hole mobility µhHT of the hole transporting material HT3 with respect to the electron mobility µeEM of the host material EM1 is about 0.03. The comparative example 3 showed green light emission, and characteristics thereof were that driving voltage E was 8.0 V and current efficiency L/J was 16 cd/A at emission luminance Lp of 13500 cd/m², and half lifetime at the time of DC driving at initial luminance Lp of 3000 cd/m² in a high temperature environment of 85°C was 1200 hours.

### (Comparative example 4)

Furthermore, in comparative example 4, except that the host material of the light-emitting layer 3b was changed to a host material EM4 and the hole transporting dopant was changed to a hole transporting material HT3, an organic EL element was prepared and characteristics thereof were measured similarly to the example 1. In the host material EM4, a ratio (µeEM/µhEM) of the electron mobility µeEM with respect to the hole mobility µhEM is 300. Furthermore, a ratio (µhHT/µeEM) of the hole mobility µhHT of the hole transporting material HT3 with respect to the electron mobility µeEM of the host material EM4 is about 26.7. The comparative example 4 showed green light emission, and characteristics thereof were that driving voltage E was 8.0 V and current efficiency L/J was 16 cd/A at emission luminance Lp of 13500 cd/m², and half lifetime at the time of DC driving at initial luminance Lp of 3000 cd/m² in a high temperature environment of 85°C was 1200 hours.

As illustrated in FIG. 2, according to the examples 1 to 7, using, as the host material of the light-emitting layer 3b, the host materials EM1 to EM3 having a ratio (µeEM/µhEM) of the electron mobility µeEM with respect to the hole mobility µhEM in the definition range (0.6 ≤ µeEM/µhEM ≤ 10) of the present invention, and further employing, as the hole transporting dopant, the hole transporting material HT1 or HT2 having a ratio (µhHT/µeEM) of the hole mobility µhHT with respect to the electron mobility µeEM of the host materials EM1 to EM3 in the definition range (0.1 ≤ µhHT/µeEM ≤ 10) of the present invention, it is possible to achieve low voltage operation and high efficiency operation, and to obtain long lifetime even in a high temperature environment. On the other hand, according to the comparative example 1 having no hole transporting dopant in the light-emitting layer 3b, the comparative examples 2 and 4 using, as the host material of the light-emitting layer 3b, the host material EM 4 having a ratio (µeEM/µhEM) of the electron mobility µeEM with respect to the hole mobility µhEM out of the definition range (0.6 ≤ µeEM/µhEM ≤ 10) of the present invention, and employing, as the hole transporting dopant, the hole transporting material HT3 having a ratio (µhHT/µeEM) of the hole mobility µhHT with respect to the electron mobility µeEM of the host material EM 4 out of the definition range (0.1 ≤ µhHT/µeEM ≤ 10) of the present invention, and the comparative example 3 employing, as the hole transporting dopant, the hole transporting material HT3 having a ratio (µhHT/µeEM) of the hole mobility µhHT with respect to the electron mobility µeEM of the host material EM1 out of the definition range (0.1 ≤ µhHT/µeEM ≤ 10) of the present invention, since driving voltage is high, light-emitting efficiency is reduced, and half lifetime in a high temperature environment becomes shorter as compared with the examples 1 to 7, characteristics of the organic EL elements are degraded. Thus, as apparent from FIG. 2, according to the present invention, it is possible to obtain an organic EL element with high reliability at low power in a high temperature environment by forming the light-emitting layer 3b. In addition, among the examples 1 to 7, since the half lifetime in a high temperature environment is relatively short in the example 4 in which the concentration of the hole transporting dopant in the light-emitting layer 3b is high, it is apparent from FIG. 2 that the concentration of the hole transporting dopant in the light-emitting layer 3b is preferably equal to or less than at least 50 weight%, and more preferably, is equal to or less than 40 weight%.

In addition, in the present embodiment, the hole injection transporting layer 3a is formed as a single layer. However, the organic EL element of the present invention may have a structure in which a hole injecting layer and a hole transporting layer are sequentially stacked. Furthermore, the light emitting dopant shows the green light emission. However, the light emitting dopant may show other light emission colors. Furthermore, a plurality of light-emitting layers or a plurality of electron transporting layers may be formed.

### [Industrial Applicability]

The present invention relates to an organic EL element, and particularly, is suitable as an organic EL element used in an apparatus, such as an in-vehicle display, which is assumed to be used in a high temperature environment.

### [Reference Signs List]

- 1: Support Substrate
- 2: First Electrode (Anode)
- 3: Organic Layer
- 3a: Hole Injection Transporting layer
- 3b: Light-emitting layer
- 3c: Electron Transporting layer
- 3d: Electron injecting layer
- 4: Second Electrode (Cathode)

## Claims

1. An organic EL element, which is formed by stacking an organic layer including at least a light-emitting layer between an anode and a cathode, wherein
the light-emitting layer includes at least a host material having a ratio (µeEM/µhEM) of electron mobility (µeEM) with respect to hole mobility (µhEM) being equal to or more than 0.6 and equal to or less than 10, a light emitting dopant emitting light, and a hole transporting dopant and
a ratio (µhHT/µeEM) of hole mobility (µhHT) of the hole transporting dopant with respect to the electron mobility (µeEM) of the host material is equal to or more than 0.1 and equal to or less than 10.

2. The organic EL element according to claim 1, wherein concentration of the hole transporting dopant in the light-emitting layer is equal to or less than 50 weight%.

3. The organic EL element according to claim 1, wherein a difference in ionization potential between the light emitting dopant and the host material is equal to or more than 0.05 eV.
